# EUROPEAN PATENT APPLICATION

(11) **EP 1 921 473 A1**
(43) Date of publication of application: **14.05.2008**
(21) Application number: 06783006.7
(22) Date of filing: 24.08.2006
(51) Int. Cl.: G02B 6/12, G02B 6/13, H05K 1/02

(54) **OPTICAL WAVEGUIDE FILM, METHOD FOR MANUFACTURING THE FILM, OPTOELECTRICAL HYBRID FILM INCLUDING THE WAVEGUIDE FILM, AND ELECTRONIC DEVICE**

(30) Priority: 29.08.2005 JP 2005248253
(71) Applicant: Mitsui Chemicals, Inc., Tokyo 105-7117 (JP)
(72) Inventor: SHIODA, Tsuyoshi c/o Mitsui Chemicals, Inc, Sodegaura-shi Chiba 299-0265 (JP)
(74) Representative: HOFFMANN EITLE
(86) International application number: PCT/JP2006/316652
(87) International publication number: WO 2007/026601

(57) **Abstract**

The present invention relates to an optical waveguide film that has a high optical coupling efficiency at a light input portion and an excellent flexibility at least a part of the film. Specifically, the present invention provides an optical waveguide film that has a core and a clad comprising a resin and has a light input portion, wherein there is a portion having a thickness smaller than that of the light input portion. Further, the present invention provides an electrical and optical hybrid film in which an electrical wiring board is joined to the optical waveguide film or an electronic device in which these films are built in.

## Description

### [TECHNICAL FIELD]

The present invention relates to a polymer optical waveguide film and an electronic device equipped with the film. In particular, the present invention relates to an optical waveguide film that is bent and disposed in an electronic device.

### [BACKGROUND ART]

A material widely used as a base material of an optical component or an optical fiber is an inorganic material such as quartz glass and multi-component glass having characteristics of a small optical propagation loss and a wide transmission band. However, recently, polymer-based materials have been developed as an optical waveguide material and have attracted attention because they are excellent in processing properties and cost compared to inorganic materials. For example, there has been prepared a flat optical waveguide film comprising a core-clad structure in which a core is made of a polymer-based material excellent in transparency such as polymethylmethacrylate (PMMA) or polystyrene and a clad is made of a polymer-based material that has a lower refractive index than the core material. Further, there has been realized a flat optical waveguide having a small optical propagation loss using polyimide that is a transparent polymer having high heat resistance (refer to Patent Document 1). Since the optical waveguide made of polymer-based materials has flexibility, it is expected that it is brought into contact with a semiconductor laser and an optical fiber made of quartz without damaging the end face and is connected at a low loss (refer to Patent Document 2).

Further, since the optical waveguide films made of polymer-based materials have flexibility, they are expected to be applied in a similar manner to that of a flexible electrical circuit board used in an electrical circuit. For example, the flexible electrical circuit board may be disposed between two portions connected by a hinge such as a cellular phone by passing across the hinge portion. In that case, the flexible electrical circuit board is rolled in an axial shape or in a hollow shape while it has flexibility depending on a curvature radius corresponding to the thickness of the hinge in the hinge portion.

In recent years, because high speed transmission and space saving are demanded in a cellular phone and the like, the flexible electrical circuit board disposed at the hinge portion is bent at a small curvature radius of approximately 2 mm. For this reason, there have emerged such problems as noise generation, deterioration of the quality of images, and so on. There may be mentioned the use of optical wiring as a technique to solve such problems. As the optical wiring, a flexible optical waveguide film may be considered.

Further, for the purpose of supplying electric power to one board, not only the optical wiring but also the electrical wiring may be required to be mounted at the hinge portion. In that case, the optical wiring and the electrical wiring may be mounted separately. However, requirements for space saving, slimming and miniaturization may be met by using an electrical and optical hybrid film in which the optical waveguide and an electrical wiring layer are integrally formed. However, the integral electrical and optical hybrid film in which the optical waveguide film and the flexible electrical wiring board are laminated has a total thickness exceeding 150 µm and there is a concern that it is inferior in bending durability.

In order to thin the thickness of the optical waveguide film, the core size of the optical waveguide film is required to be reduced. As the core size is reduced, the displacement tolerance is reduced, leading to the reduction of the optical coupling efficiency. For example, when the alignment is performed in order to optically couple the optical waveguide film and other optical components, the core diameter of the light input portion is required to be approximately 100 µm to 150 µm. In addition, the total film thickness of the optical waveguide film is the thickness of the core diameter plus approximately 30 µm. If the bent portion has such thickness, the optical loss as well as the breakage of the optical waveguide may occur depending on the thickness. Further, if the bent portion is integrated with the electrical wiring board, the total thickness becomes further thicker by 10 to 50 µm and the flexibility is further deteriorated.
Patent Document 1: Japanese Patent Laid-Open Publication No. H04-9807
Patent Document 2: Japanese Patent Laid-Open Publication No. 2002-318318

### [DISCLOSURE OF THE INVENTION]

### [PROBLEMS TO BE SOLVED BY THE INVENTION]

An object of the present invention is to provide an optical waveguide film that has a high optical coupling efficiency at a light input portion and an excellent flexibility in order to avoid the above problems.

### [MEANS FOR SOLVING THE PROBLEMS]

The present inventors have found that the above problems were solved by reducing the film thickness at a part of an optical waveguide film and bending the film at the part and have completed the present invention.

In other words, the first of the present invention relates to an optical waveguide film or an electrical and optical hybrid film shown below.
[1] An optical waveguide film having a core and a clad comprising a resin and having a light input portion, wherein the optical waveguide film has a thinner portion having a film thickness smaller than that of the light input portion.
[2] The optical waveguide film described in [1], wherein the light input portion is a film end portion among the both film end portions in the waveguide direction, which end portion has a thickness larger than or equal to that of the other end portion.
[3] The optical waveguide film described in [1] or [2], wherein the minimum thickness of the film at the thinner portion is 10% to 80% of the film thickness of the light input portion.
[4] The optical waveguide film described in any of [1] to [3], wherein the core thickness at the thinner portion is smaller than the core thickness at the light input portion.
[5] The optical waveguide film described in any of [1] to [4], wherein a groove extending in the waveguide direction is provided.
[6] An electrical and optical hybrid film comprising the optical waveguide film described in any of [1] to [5] and an electrical wiring board joined to one surface or both surfaces of the optical waveguide film.

The second of the present invention relates to an electronic device equipped with the film.
[7] An electronic device in which the optical waveguide film described in any of [1] to [5] is built in, wherein the optical waveguide film is bent at the thinner portion.
[8] The electronic device in which the electrical and optical hybrid film described in [6] is built in, wherein the optical waveguide film is bent at the thinner portion.

The third of the present invention relates to a method for manufacturing an optical waveguide film described below.
[9] A method for manufacturing an optical waveguide film having a core and a clad comprising a resin and having a light input portion, wherein the optical waveguide film has a portion having a thickness smaller than that of the light input portion, comprising the steps of:
   coating a solution of the core material or the clad material, or a precursor thereof; and
   removing a part of the coated solution.
[10] A method for manufacturing an optical waveguide film having a core and a clad comprising a resin and having a light input portion, wherein the optical waveguide film has a portion having a thickness smaller than that of the light input portion, comprising the step of:
   coating a solution of the core material or the clad material, or a precursor thereof by using an applicator equipped with an applicator head provided with a film thickness controlling element.

### EFFECT OF THE INVENTION

Since the optical waveguide film of the present invention is thin at least at a part of its intermediate portion in the waveguide direction, it is excellent in flexibility at the thinner portion. Accordingly, the optical waveguide film of the present invention is housed in an electronic device by bending the thinner portion, thereby enabling realization of space saving, slimming and miniaturization.
In addition, the light input portion (for example, the film end portion) of the optical waveguide film of the present invention has a sufficient thickness, thereby facilitating handling for the connection with other optical components. Further, since the core thickness of the light input portion may be increased, the optical coupling efficiency may be increased.

### BRIEF DESCRIPTION OF THE DRAWINGS

[Fig. 1] Fig. 1 shows an example of the optical waveguide film of the present invention. In Fig. 1A, the film end portion is shown as the light input portion and in Fig. 1B, a portion in which a mirror for optical path conversion is formed is shown as the light input portion.
[Fig. 2] Fig. 2 shows an example of the optical waveguide film of the present invention.
[Fig. 3] Fig. 3 shows an example of a method for manufacturing the optical waveguide film of the present invention.
[Fig. 4] Fig. 4 shows an example of another method for manufacturing the optical waveguide film of the present invention.

### [BEST MODE FOR CARRYING OUT THE INVENTION]

1. Optical Waveguide Film and Electrical and optical Hybrid Film of the Present Invention
The optical waveguide film of the present invention includes a core and a clad and further optional members. Both the core and the clad are preferably comprising a resin material in order to obtain flexibility of the optional waveguide film. The example of the resin material includes a polyimide resin (including a fluorine-based polyimide resin), a silicone-modified epoxy resin, a silicone-modified acrylic resin, a silicone-modified polynorbornene and the like.

The optical waveguide film of the present invention has a light input portion that is a region where light as a signal is inputted, and has a portion that has a film thickness smaller than the light input portion.

The light input portion of the optical waveguide film is a region where light that is optically coupled with other optical components as a signal is inputted. The configuration of the light input portion is not particularly limited, for example, the light input portion may be a film end portion in the waveguide direction. When both end portions of the film in the waveguide direction have different thicknesses, the film end portion having a larger thickness is preferably used as the light input portion. In addition, the light input portion may not be at the film end portion in the waveguide direction but may be at the intermediate portion. When the light input portion is at the intermediate portion, there are provided a path for inputting light into the optical waveguide film and a path for outputting light. For example, a path for penetrating light can be provided on the clad layer by providing a mirror on the core in the film.

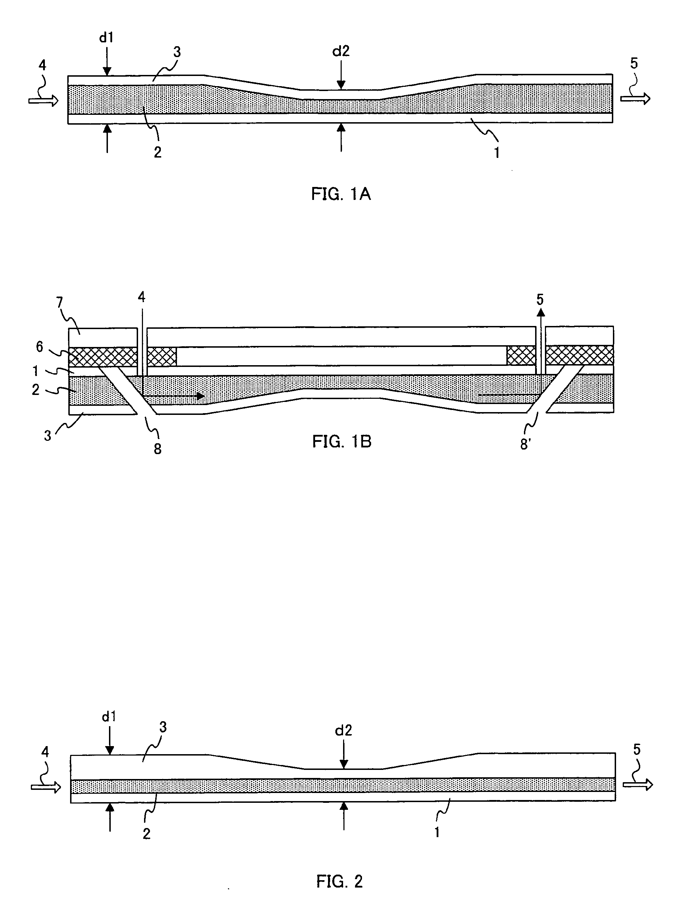

Fig. 1B shows an example of an electrical and optical hybrid film having an optical waveguide film in which the light input portion is the film intermediate portion. The portion in the vicinity of both ends of the optical waveguide film having a lower clad 1, core 2 and upper clad 3 is joined to an electrical wiring board 7 via an adhesive layer 6. The core 2 of the center portion of the optical waveguide film is thinned and the optical waveguide film itself is also thinned. The working holes 8 and 8' that are used as a mirror are formed in the optical waveguide. In addition, there are formed a light input portion 4 and a light output portion 5 that penetrate the electrical wiring board 7, adhesive layer 6 and upper clad 1.
The light inputted from the light input portion 4 is reflected by the working hole 8 to proceed to the core 2, further is reflected by the working hole 8', and then is outputted from the light output portion 5.

The core thickness of the light input portion of the optical waveguide film is not particularly limited, but preferably is 100 to 150 µm in order to increase the optical coupling efficiency with other optical components. The film thickness of the light input portion typically is a thickness added with 30 µm or more to the core thickness. Since the light input portion is required to be optically coupled with other optical components, it has more than a certain film thickness to facilitate the handling in connecting to a connector for coupling.

"A thinner portion" of the optical waveguide film may be at any place except for the light input portion and may be either in the vicinity of the film center in the waveguide direction or at a region near the film end portion. In addition, the thinner portion may be at one place or two or more places in the optical waveguide film. As mentioned later, the optical waveguide film of the present invention is preferably bent at the thinner portion.

The minimum thickness of the film at the thinner portion preferably is approximately 10% to 80% of the film thickness of the light input portion. Further, the minimum thickness of the film at the thinner portion preferably is 120 µm or less in order to increase the flexibility at the thinner portion. In addition, the core thickness at the thinner portion preferably is smaller than the core thickness of the light input portion. However, the core thickness at the thinner portion is preferably typically 10 µm or more in order to prevent excessive optical loss.

As mentioned above, the core thickness at the thinner portion of the optical waveguide film of the present invention is preferably smaller than the core thickness of the light input portion, and a slope of the core is preferably gradual in order to reduce the optical loss (optical leakage). In addition, the slope angle (gradient) is not particularly limited, it may be set accordingly depending on the range of the tolerable optical loss, for example, approximately 0.1° to 2° is satisfactory. The length of the sloping core in the waveguide direction varies depending on the angle of the slope, the difference in the core thickness between the light input portion and the thinner portion, and the like.

As mentioned above, the optical waveguide film of the present invention has a thinner portion, and at the thinner portion, the core may be thinned, the clad may be thinned, or both the core and the clad may be thinned.
Fig. 1 shows a cross section of an optical waveguide film in which the clad thickness is nearly constant over the whole film but the core thickness is thinned at a part of the film (at a central portion in the waveguide direction) . On the other hand, Fig. 2 shows a cross section of an optical waveguide film in which the core thickness is nearly constant over the whole film but the clad thickness is thinned at a part of the film (at a central portion in the waveguide direction).

The optical waveguide films shown in Fig. 1 and Fig. 2 are an integrated film in which the core 2 is sandwiched between the lower clad 1 and the upper clad 3. In the optical waveguide films shown in Fig. 1A and Fig. 2, an optical signal is inputted from the light input portion 4 that is the film end portion to the optical waveguide and is outputted from the light output portion 5 through the optical waveguide. Typically, the film thickness d1 of the light input portion 4 is set equal to or larger than the film thickness of the light output portion 5.
The film thickness d2 of the central portion in the longitudinal direction of the optical waveguide (in the waveguide direction) is set smaller than the film thickness d1 of the light input portion 4 in order to increase the flexibility at the central potion. The film thickness d2 of the central portion is preferably 10% to 80% of the film thickness d1 of the light input portion 4 and further the film thickness d2 is preferably 120 µm or less.

The optical waveguide of the present invention may have a groove extending in the waveguide direction on the film surface. The core of the optical waveguide film may be in contact with the side surface of the groove extending to the waveguide direction and may be spaced from the side surface of the groove. The groove extending in the waveguide direction is preferably disposed at least at a thinner portion of the optical waveguide film, that is, at a bent portion. The film thickness at the bottom of the groove is not particularly limited, but is preferably set at the half or less of the thickness of the optical waveguide film. The groove may increase the flexibility.

On the other hand, the electrical and optical hybrid film of the present invention has the above-mentioned optical waveguide film and an electrical wiring board joined to one surface or both surfaces of the optical waveguide film. However, the electrical wiring board is preferably not joined to the thinner portion of the optical waveguide film. For example, the electrical wiring board may only be joined in the vicinity of the both end portions of the optical waveguide film (refer to Fig. 1B). As mentioned above, this is in order to maintain the flexibility because the optical waveguide film may be bent at the thinner portion.

The electrical and optical hybrid film is optically and electrically connected with other members using a connector and the like. For example, a spring-like electrode is electrically connected with an exposed part of the wiring portion in the upper surface or the rear surface of the hybrid film; and a light receiving or emitting element is optically connected with the end face of the hybrid film.

Although the optical waveguide film or the electrical and optical hybrid film of the present invention may be used for arbitrary applications, it is suitable for a circuit that is used as bent in electronic devices such as cellular phones. For example, it may be used as a circuit that connects two portions connected by a hinge by passing across the hinge. Here, the portion bent (for example, a portion corresponding to the hinge) is preferably disposed at the thinner portion of the optical waveguide film.

2. Method for Manufacturing the Optical waveguide Film of the Present Invention
The optical waveguide film of the present invention is manufactured by an arbitrary method and may be manufactured by applying a similar method to that of a usual optical waveguide film except that a portion thinner than a light input portion is formed. The method of forming the thinner portion includes the following two methods (method A and method B).
Method A: A solution of a core material or a clad material or a precursor thereof is coated, and then a part of the coated solution is removed to form a thinner portion.
Method B: A solution of a core material or a clad material or a precursor thereof is coated by using an applicator equipped with an applicator head having a film thickness controlling element to form a thinner portion.

The precursor refers to a polyamide acid and the like and is converted to a polyimide by a thermal treatment and the like, when, for example, the core material or the clad material is a polyimide. In general, a solution of the clad material or its precursor is coated on a substrate, or a core layer, and the core material or its precursor is coated on the clad layer. The viscosity of the coating solution is determined accordingly depending on the manufacturing conditions and typically is approximately 1 Pa·s to several tens of Pa·s. The viscosity of the solution may be measured by using an E-Type viscometer (a cone-plate type rotary viscometer).

In the method A, when a part of the core of the optical waveguide film is thinned, a part of the coating solution of the core material or its precursor needs to be removed. On the other hand, when the clad is thinned, a part of the coating solution of the clad material or its precursor needs to be removed. The amount of the coating solution may be determined accordingly depending on the thickness of the core or clad to be formed.

In the method A, means for removing a part of the coating solution are not particularly limited, and for example, a removal film (a film for removing a part of the coating solution) may be brought into contact with the coating film followed by peeling off the removal film. The examples of the removal film that is contacted with the coating film include a PET film and the like. The width of the removal film may be determined depending on the amount of the solution to be removed. For example, there may be used the removal film having a width of approximately 1.5 times the width of the optical waveguide film to be thinned. In addition, the process of removing a part of the solution may be carried out once or two or more times.

In the method A, after removing the part of the solution, the coating film may be leveled (smoothed) by allowing to stand for a fixed period of time. By so doing, a gradual slope may be obtained and thus the optical loss may be reduced even if the core is inclined. Further, a thermal treatment is preferably performed in order to remove the solvent in the coating film or to convert the precursor into the core material or clad material.

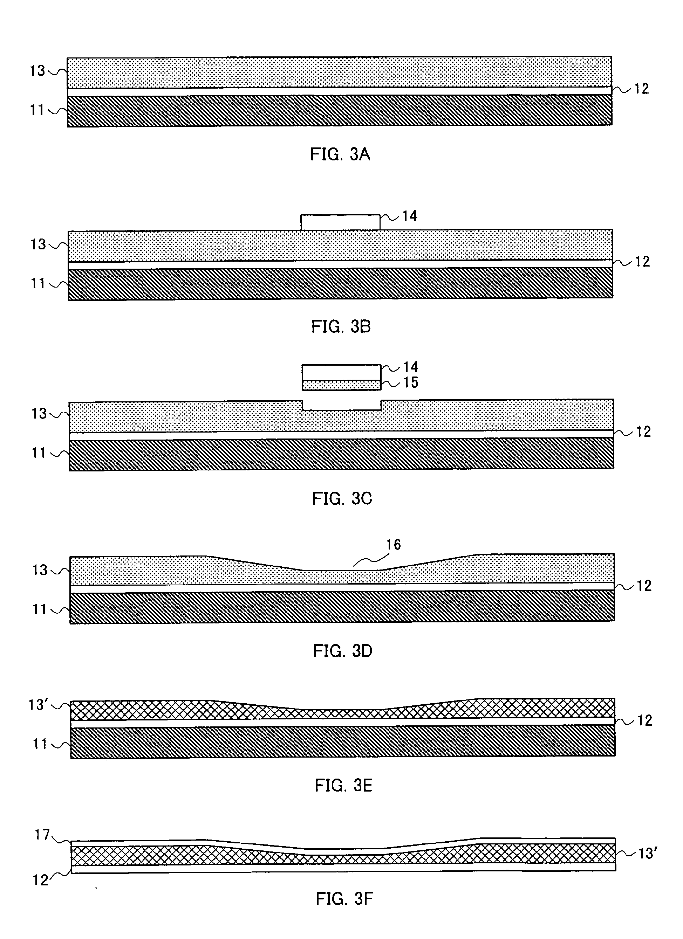

Fig. 3 shows an example of the manufacturing process of an optical waveguide film by the method A.
A solution of a polyamide acid that is a precursor of the polyimide to be used as a clad material is applied on a substrate 11 such as a silicon wafer or the like, and the formed coating film is thermally treated to form a lower clad layer 12. Thereafter, a solution of the polyamide to be used as a core material is applied to form a coating film 13 (Fig. 3A). The thickness of the coating film 13 is adjusted accordingly depending on the required core size.

Next, a band film 14 is slowly brought into contact with the coating film 13 (Fig. 3B). Thereafter, the film 14 is slowly peeled off from the coating film 13 (Fig. 3C). A part 15 of the polyamide acid solution of the coating film 13 adheres to the peeled film 14. The liquid surface of the polyamide acid solution of the coating film 13 is leveled by allowing to stand as it is and then a gentle dent 16 is formed when viewed from the cross section (Fig. 3D).

The film thickness distribution of the coating film 13 leveled depends on the viscosity of the solution, resin concentration and a time to allow the film to stand. After allowing to stand for a predetermined period of time, the coating film is heated to cure. In this way, a core 13' that is partially thinned is formed (Fig. 3E).

A polyamide acid solution to be used as an upper clad layer 17 is applied on the formed core layer 13' and cured by thermal treatment to form a polyimide. Here, the thickness of the upper clad layer 17 is preferably thinned without occurring optical leakage. For example, when the relative refractive index difference between the core layer 13' and the upper clad layer 17 is 1%, the thickness of the upper clad layer 17 may be about 5 µm. A laminated film obtained by laminating the lower clad layer 12, the core layer 13' and the upper clad layer 17 in this order is peeled off from the substrate 11 (Fig. 3F).

On the laminated film thus obtained, two grooves are formed on the surface of the upper clad layer 17 by mechanical processing using a dicing saw or the like. Preferably, the grooves completely cut off the clad layer 17 and the core layer 13', and further cut to the half way of the lower clad layer 12. The core width is defined by the two grooves and the portion sandwiched by the two grooves is a core pattern.

Further, a desired optical waveguide film may be obtained by cutting out to a size necessary for handling.

As mentioned above, the laminated film may be prepared by laminating the lower clad layer 12, the core layer 13' and the upper clad layer 17 in this order, but it may be prepared by preparing a core film having a film thickness distribution so as to thin a portion and then forming a clad layer on both sides of the core film.

On the other hand, in the method B, a solution is applied by using an applicator equipped with an applicator head having a film thickness controlling element. The type of the applicator is not particularly limited and includes, for example, a dye coater and the like. The thickness of the coating film is controlled by the film thickness controlling element provided on the head of the applicator.

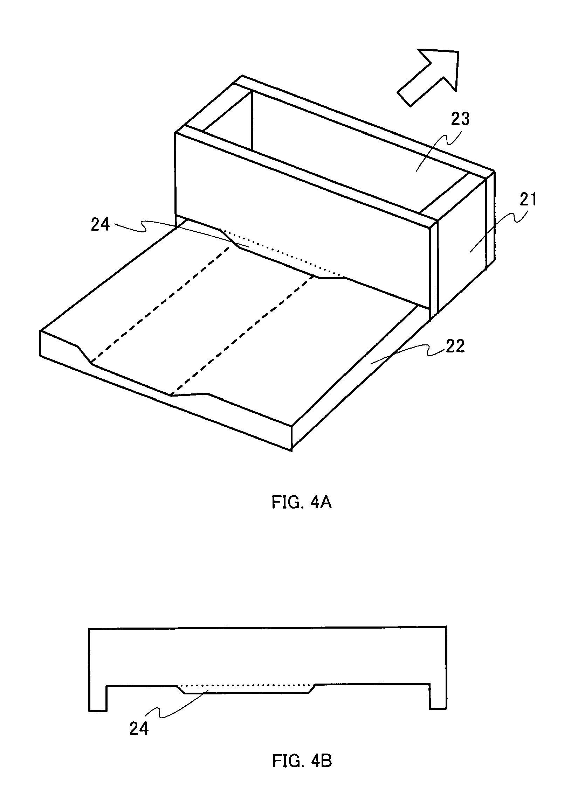

Fig. 4A shows a way of applying a solution on a coating board 22 by using an applicator 21. The coating solution is applied on the coating board 22, while the applicator 22 which is filled with the coating solution through a resin filling opening 23 is moved in the direction of the arrow in Fig 4A.
As shown in Fig. 4B, the applicator head (a member from which the coating solution is injected) of the applicator 21 has a film thickness controlling element 24. The shape and size of the film thickness controlling element 24 may be determined accordingly depending on the desired film shape, whereby the film having a thinner portion is formed. For example, a coating film having a thinner portion may be formed by making the film thickness controlling element 24 in a smooth convex form. The coating film obtained by applying a solution by an applicator may be heated to cure in a similar way to that of the method A.

Further, an electrical and optical hybrid film may be manufactured by the following process. A flexible electrical wiring board or a copper-clad laminated substrate before patterning copper layer is attached to one side or both sides of a laminated film in which an upper clad layer, a core layer and a lower clad layer are laminated in this order. As an adhesive layer material for the attachment step, a thermoplastic polyimide and the like may be used. When the copper is not patterned, the wiring board is subjected to patterning and the like after the attachment step. Thereafter, a groove is formed by mechanical processing using a dicing saw or the like to conduct the core patterning. In this way, the electrical and optical hybrid film may be manufactured.

### EXAMPLES

Hereinafter, the present invention will be explained in more detail with reference to examples, but the scope of the present invention is not limited by these examples. For example, it is clear that various optical waveguide films and various electrical and optical hybrid films of the present invention may be obtained by using various polymers having different molecular structures.

As a polyamide acid solution for the clad material, there was used a polyamide acid solution (OPI-N1005: Hitachi Chemical Co., Ltd.) of 2,2-bis(3,4-dicarboxyphenyl)hexafluoropropane dianhydride (6FDA), and 2,2-bis(trifluoromethyl)-4,4'-diaminobiphenyl (TFDB).
Meanwhile, as a polyamide acid solution for the core material, there was used a polyamide acid solution (OPI-N3405: Hitachi Chemical Co., Ltd.) of a copolymer of 6FDA and TFDB, and 6FDA and 4,4'-oxydianiline (ODA).

The viscosity of the polyamide acid solution for the core material was 7 Pa·s. The viscosity was measured by using an E-Type viscometer (a cone-plate type rotary viscometer) at 25°c.

### [EXAMPLE 1]

The polyamide acid solution for the clad material was spin coated on a 5-inch silicon wafer and the coating film was thermally treated to form a lower clad layer. The lower clad layer formed had a thickness of 20 µm.

The polyamide acid solution for the core material was spin coated on the lower clad layer formed. The coating film had a thickness of 600 µm. Next, a PET film with a width of 15 mm was slowly placed on the coating film in the vicinity of the center of the wafer and was subsequently peeled off from the edge of the PET film. A film with a thickness of approximately 300 µm adhered to the PET film. After allowing to stand for approximately 10 minutes, the wafer was thermally treated in an oven to form a core layer. The thickness (the minimum thickness) in the vicinity of the center of the core layer was approximately 75 µm and the thickness of the core layer at a portion 30 mm away from the center was approximately 140 µm. The film thickness of the core layer between the two changed continuously, the slope of the core layer is approximately 0.2 degrees.

The polyamide acid solution for the clad material was spin coated on the core layer formed and the coating film was thermally treated to form an upper clad layer with a thickness of 5µm.

The resultant laminated film was peeled off from the silicon wafer. A dicing tape was adhered to the lower clad layer of the peeled laminated film. Two linear grooves with a length of 100 mm were formed by using a dicing saw on the upper clad layer side of the laminated film to which the dicing tape was adhered. The formed grooves were made to cut the core layer and the region between the two grooves was used as a core pattern. The core width was set to 100 µm. The thickness (the minimum thickness) in the vicinity of the center of the film was approximately 100 µm and the thickness at the edge portion of the film that is to be light input portion was approximately 165 µm. A part (width: 3 mm; length: 100 mm) including the two grooves formed was cut out from the resultant film to obtain an optical waveguide film.

A bending test was carried out for the resultant optical waveguide film. The bending test was performed in accordance with the folding endurance test described in JIS C 5016. The number of bendings until the optical waveguide film was broken was measured by bending the film at a thin portion of the center of the optical waveguide film with a bending radius of 2 mm, which yielded 110, 000 times.

On the other hand, a part with a width of 3 mm and a length of 100 mm was cut out from the laminated film (in which no grooves are formed) obtained in Example 1. The cut out sample was subjected to a similar bending test to the above. The optical waveguide film was broken at 80,000 bendings.

### [EXAMPLE 2]

The polyamide acid solution for the clad material was spin coated on a 5-inch silicon wafer and the coating film was thermally treated to form a lower clad layer. The lower clad layer formed had a thickness of 20 µm.

The polyamide acid solution for the core material was spin coated on the lower clad layer formed. The coating film had a thickness of 600 µm. Next, a PET film with a width of 15 mm was slowly placed on the coating film in the vicinity of the center of the wafer and was subsequently peeled off from the edge of the PET film. A film with a thickness of approximately 300 µm adhered to the PET film. The wafer was allowed to stand for approximately 10 minutes. Further, in a similar way, after slowly placing a PET film with a width of 10 mm on the coating film in the vicinity of the center of the wafer, it was peeled off from the edge. After allowing to stand for approximately 10 minutes, the wafer was thermally treated in a oven to form a core layer. The thickness (the minimum thickness) in the vicinity of the center of the core layer was approximately 30 µm, and the thickness of the core layer at a portion 30 mm away from the center was approximately 140 µm. The film thickness of the core layer between the two changed continuously, a slope of the core layer is approximately 0.6 degrees.

The polyamide acid solution for the clad material was spin coated on the core layer formed and the coating film was thermally treated to form an upper clad layer with a thickness of 5 µm.

The resultant laminated film was peeled off from the silicon wafer. A dicing tape was adhered to the lower clad layer of the peeled laminated film. Two linear grooves with a length of 100 mm were formed by using a dicing saw on the upper clad layer side of the laminated film to which the dicing tape was adhered. The formed grooves were made to cut the core layer and the region between the two grooves was used as a core pattern. The core width was set at 100 µm. The thickness (the minimum thickness) in the vicinity of the center of the film was approximately 55 µm, and the thickness at the edge portion of the film that is used as the light input portion was approximately 165 µm. A part (width: 3 mm; length: 100 mm) including the two grooves formed was cut out from the resultant film to obtain an optical waveguide film.

A bending test was carried out for the resultant optical waveguide film. The bending test was performed in accordance with the folding endurance test described in JIS C 5016. The number of bending until the optical waveguide film was broken was measured by bending the film at a thin portion in the center of the optical waveguide film at a bending radius of 2 mm, which yielded 240,000 times.

On the other hand, a part with a width of 3 mm and a length of 100 mm was cut out from the laminated film (in which no grooves are formed) obtained in Example 2. The cut out sample was subjected to a similar bending test to the above. The optical waveguide film was broken at 180,000 bendings.

### [COMPARATIVE EXAMPLE]

The polyamide acid solution for the clad material was spin coated on a 5-inch silicon wafer and the coating film was thermally treated to form a lower clad layer. The lower clad layer formed had a thickness of 20 µm.

The polyamide acid solution for the core material was spin coated on the lower clad layer formed. The coating film had a thickness of 600 µm. The coating film was thermally treated in an oven to form a core layer with a thickness of approximately 140 µm.

The polyamide acid solution for the clad material was spin coated on the core layer formed and the coating film was thermally treated to form an upper clad layer with a thickness of 5 µm.

The resultant laminated film was peeled off from the silicon wafer. A dicing tape was adhered to the lower clad layer of the peeled laminated film. Two linear grooves with a length of 100 mm were formed by using a dicing saw on the upper clad layer side of the laminated film to which the dicing tape was adhered. The formed grooves were made to cut the core layer and the region between the two grooves was used as a core pattern. The core width was set at 100 µm. The film thickness was nearly uniform and was approximately 173 µm. A part (width: 3 mm; length: 100 mm) including the two grooves formed was cut out from the resultant film to obtain an optical waveguide film.

A bending test was carried out for the resultant optical waveguide film. The bending test was performed in accordance with the folding endurance test described in JIS C 5016. The number of bendings until the optical waveguide film was broken was measured by bending the film at a thin portion in the center of the optical waveguide film at a bending radius of 2 mm, which yielded 10,000 times.

On the other hand, a part with a width of 3 mm and a length of 100 mm was cut out from the laminated film (in which no grooves are formed) obtained in Comparative Example. The cut out sample was subjected to a similar bending test to the above. The optical waveguide film was broken at 6,000 bendings.

### INDUSRIAL APPlICABILITY

The optical waveguide film of the present invention may be built in and used in an electronic device requiring an optical wiring and may be especially used where it is bent or wound around a hinge in a small space.

The present application claims priority based on Japanese Patent Application No. 2005-248253 filed on Aug. 29, 2005, the disclosure of which is hereby incorporated herein by reference in its entirety.

## Claims

1. An optical waveguide film having a core and a clad comprising a resin and having a light input portion, wherein the optical waveguide film has a thinner portion having a film thickness smaller than that of the light input portion.

2. The optical waveguide film according to claim 1, wherein the light input portion is a film end portion among the both film end portions in the waveguide direction, which end portion has a thickness larger than or equal to that of the other end portion.

3. The optical waveguide film according to claim 1, wherein the minimum thickness of the film at the thinner portion is 10% to 80% of the film thickness of the light input portion.

4. The optical waveguide film according to claim 1, wherein the core thickness at the thinner portion is smaller than the core thickness at the light input portion.

5. The optical waveguide film according to claim 1, wherein a groove extending in the waveguide direction is provided.

6. An electrical and optical hybrid film, comprising the optical waveguide film according to claim 1 and an electrical wiring board joined to one surface or both surfaces of the optical waveguide film.

7. An electronic device in which the optical waveguide film according to claim 1 is built in, wherein the optical waveguide film is bent at the thinner portion.

8. An electronic device in which the electrical and optical hybrid film according to claim 6 is built in, wherein the optical waveguide film is bent at the thinner portion.

9. A method for manufacturing an optical waveguide film having a core and a clad comprising a resin and having a light input portion, wherein the optical waveguide film has a portion having a thickness smaller than that of the light input portion, comprising the steps of:
coating a solution of the core material or the clad material, or a precursor thereof; and
removing a part of the coated solution.

10. A method for manufacturing an optical waveguide film having a core and a clad comprising a resin and having a light input portion, wherein the optical waveguide film has a portion having a thickness smaller than that of the light input portion , comprising the step of:
coating a solution of the core material or the clad material, or a precursor thereof using an applicator equipped with an applicator head provided with a film thickness controlling element.
